# EUROPEAN PATENT APPLICATION

(11) **EP 4 712 707 A1**
(43) Date of publication of application: **18.03.2026**
(21) Application number: 25201448.5
(22) Date of filing: 10.09.2025
(51) Int. Cl.: H05K 1/11, H05K 1/181, H01G 4/38, H05K 1/02

(54) **HIGH-DENSITY DECOUPLING CAPACITOR ROUTING OPTIMIZING CAPACITANCE WITH CONSIDERATION FOR HIGH-YIELD MANUFACTURING**

(30) Priority: 17.09.2024 US 202418887680
(71) Applicant: Nokia Solutions and Networks Oy, 02610 Espoo (FI)
(72) Inventor: Fazari, Daniel, Carleton Place K7C3W7 (CA); Chan, Alex, Ottawa K2J5X9 (CA); Brown, Paul, Wakefield J0X 3G0 (CA); Webb, Wesley, Ottawa K2R 1G5 (CA)
(74) Representative: Swindell & Pearson Limited

(57) **Abstract**

A multi-layer printed circuit board includes a substrate having a first side and a second side opposite the first side, a central via pad disposed on the first side and having a plurality of central-extensions extending outwardly therefrom, a first via pad disposed on the first side and having at least one first-extension extending outwardly therefrom, a second via pad disposed on the first side and having at least one first-extension extending outwardly therefrom, wherein each central-extension has a first-connection-edge, wherein each first-extension has a second-connection-edge, wherein a first first-connection edge of a first central-extension faces a second-connection-edge of the first via pad, and a line perpendicular to the first first-connection edge and to the second-connection-edge of the first via pad forms an angle with a via-to-via axis line between the central via pad and the first via pad, and the angle is greater than a predetermined threshold angle.

## Description

### FIELD OF THE DISCLOSURE

Various exemplary embodiments disclosed herein relate to the structure and manufacturing of electronic products having printed circuit boards.

### BACKGROUND

It is common in electronic products and systems, including those implemented with integrated circuits and printed circuit boards, to provide decoupling capacitors. Decoupling capacitors are useful for, among other things, reducing noise or interference that may adversely affect the performance of an electronic product or system.

### SUMMARY

A summary of various illustrative embodiments is presented below.

According to an aspect of this disclosure, an apparatus includes a substrate having a first side and a second side opposite the first side, a central via pad disposed on the first side and having a plurality of central-extensions extending outwardly therefrom, a first via pad disposed on the first side and having at least one first-extension extending outwardly therefrom, a second via pad disposed on the first side and having at least one first-extension extending outwardly therefrom, wherein each central-extension of the plurality of central-extensions has a first-connection-edge, wherein each first-extension has a second-connection-edge, and wherein a first first-connection edge of a first central-extension faces a second-connection-edge of the first via pad, and a line perpendicular to the first first-connection edge and to the second-connection-edge of the first via pad forms an angle with a via-to-via axis line between the central via pad and the first via pad, wherein the angle is greater than a predetermined threshold angle.

In some embodiments a second first-connection edge of a second central-extension faces a second-connection-edge of the second via pad, and a line perpendicular to the second first-connection edge and to the second-connection-edge of the second via pad forms a second angle with a via-to-via axis line between the central via pad and the second via pad, wherein the second angle is greater than the predetermined threshold angle.

Some embodiments further include a third via pad disposed on the first side and having at least one first-extension extending outwardly therefrom, wherein a third first-connection edge of a third central-extension faces a second-connection-edge of the third via pad, and a line perpendicular to the third first-connection edge and to the second-connection-edge of the third via pad forms a third angle with a via-to-via axis line between the central via pad and the third via pad, wherein the third angle is greater than zero and greater than the predetermined threshold angle.

In some embodiments, the first angle, the second angle, and the third angle are nominally the same.

In some embodiments, the substrate comprises a multi-layer printed circuit board.

According to another aspect of this disclosure, an electronic product includes a substrate having a top side and a bottom side, a first via pad having a plurality of extensions extending outwardly therefrom, disposed on the bottom side, a second via pad, a third via pad, a first component having a first horizontal axis, a first terminal, and a second terminal, the first component disposed on the bottom side between the second via pad and a first extension of the plurality of extensions such that the first horizontal axis forms an angle α with respect to a first via-to-via axis line between the first via pad and the second via pad, wherein α is greater than a threshold angle, and a second component having a second horizontal axis, a third terminal, and a fourth terminal, the second component disposed on the bottom side between the third via pad and a second extension of the plurality of extensions such that the second horizontal axis forms an angle β with respect to a second via-to-via axis line between the first via pad and the third via pad, wherein β is greater than the threshold angle.

In some embodiments, the first terminal is coupled to the second via pad, the second terminal is coupled to the first extension, the third terminal is coupled to the third via pad, the fourth terminal is coupled to the second extension, and a first component gap between the second terminal and the fourth terminal is greater than a threshold distance.

In some embodiments the electronic product further includes a fourth via pad, and a third component having a third horizontal axis, a fifth terminal, and a sixth terminal, the third component disposed on the bottom side between the fourth via pad and a third extension of the plurality of extensions such that the third horizontal axis forms an angle γ with respect to a third via-to-via axis line between the first via pad and the fourth via pad, wherein γ is greater than the threshold angle, wherein a second component gap between the fourth terminal and sixth terminal is greater than the threshold distance, and a third component gap between the second terminal and sixth terminal is greater than the threshold distance.

In some embodiments, the angle α, the angle β, and the angle γ, are nominally the same angle.

In some embodiments, a magnitude of the threshold angle is such that the first component gap, the second component gap, and the third component gap are greater than the threshold distance.

In some embodiments, the electronic product further includes a fourth component disposed on the top side of the substrate, a first ground plane coupled to the first via pad, a first power plane coupled to the second via pad, a second power plane coupled to the third via pad, and a third power plane coupled to the fourth via pad, wherein the substrate is a multi-layer substrate, and the first power plane, the second power plane, and the third power plane are each on a different layer of the multi-layer substrate.

In some embodiments, the first component, the second component, the third component, and the fourth component are each a surface-mount device.

In some embodiments, at least one of the first component, the second component, and the third component comprises a capacitor.

In some embodiments, the fourth component comprises a ball grid array package.

In some embodiments, the substrate comprises a multi-layer printed circuit board.

According to a further aspect of this disclosure, a method of manufacturing an electronic product includes providing a multi-layer printed circuit board (PCB) having a top side and a bottom side, the multi-layer PCB having a central via pad, a first via pad, a second via pad, and a third via pad, wherein the first via pad, the second via pad, and the third via pad, are each spaced apart from the central via pad, and the central via pad has a plurality of extensions extending outwardly therefrom on the bottom side, placing a first component having a first horizontal axis between the central via pad and the first via pad such that the first horizontal axis is angled away from a first via-to-via axis between the central via pad and the first via pad by a first amount, placing a second component having a second horizontal axis between the central via pad and the second via pad such that the second horizontal axis is angled away from a second via-to-via axis between the central via pad and the second via pad by a second amount, placing a third component having a third horizontal axis between the central via pad and the third via pad such that the third horizontal axis is angled away from a third via-to-via axis between the central via pad and the third via pad by a third amount, and performing a reflow solder operation, wherein a first component gap between the first component and the second component, a second component gap between the second component and the third component, and a third component gap between the third component and the first component, are each greater than a predetermined distance.

In some embodiments, each of the first component, the second component, and the third component are two-terminal, surface-mount devices, and the first via pad, the second via pad, and the third via pad are nominally equidistant from the central via pad.

In some embodiments of the method, the first component, the second component, and the third component are each 0201 size capacitors disposed on the bottom side, and further including placing a fourth component on the top side, wherein the fourth component is a surface-mount device, and the fourth component is located vertically over the central via pad.

In some embodiments of the method, the central via pad is coupled to a ground plane, the first via pad is coupled to a first voltage plane, the second via pad is coupled to a second voltage plane, and the third via pad is coupled to a third voltage plane.

In some embodiments of the method, the first amount, the second amount, and the third amount, are nominally the same.

### BRIEF DESCRIPTION OF DRAWINGS

To better understand various illustrative embodiments, reference is made to the accompanying drawings, wherein:
FIG. 1A is a cross-sectional view of a portion of a multi-layer printed circuit board (PCB) having vias between a top side and a bottom side thereof;
FIG. 1B is a cross-sectional view of a portion of a multi-layer PCB having blind vias between a bottom side and an interior layer of the PCB, and plated through vias between a top side and a bottom side;
FIG. 2A is a top view of a portion of a PCB showing an orthogonal arrangement of via pads;
FIG. 2B is a top view of a portion of a PCB showing a non-orthogonal arrangement of via pads;
FIG. 3A is a bottom view of an illustrative ball grid array (BGA) package;
FIG. 3B is a side view of an illustrative BGA package of FIG. 3A;
FIG. 4A is a top view of a two-terminal surface mount device (SMD) package;
FIG. 4B is a perspective view of the two-terminal SMD package of FIG. 4A;
FIG. 5 is a bottom view of a portion of a multi-layer PCB having three SMD components mounted on the bottom side and each of the three SMD components coupled in common to a single via pad in a Y-configuration;
FIG. 6A is a bottom view of an illustrative multi-layer PCB showing a metal layout, in accordance with this disclosure;
FIG. 6B shows an enlarged portion of FIG. 6A;
FIG. 6C shows an alternative embodiment in accordance with this disclosure;
FIG. 7 is a bottom view of a portion of the PCB of FIG. 6, on which a plurality of SMD components have been mounted in accordance with this disclosure; and
FIG. 8 is a flow diagram of a method in accordance with this disclosure.

To facilitate understanding, identical reference numerals have been used to designate elements having substantially the same or similar structure and/or substantially the same or similar function.

### DETAILED DESCRIPTION

Various embodiments in accordance with this disclosure provide a physical arrangement for the high-density placement of surface mount technology (SMT) components that is consistent with high-yield manufacturing procedures. SMT components may include, but are not limited to, capacitors, resistors, and inductors. One common application of SMT capacitors is decoupling. It is noted that an SMT component may also be referred to as a surface mount device (SMD).

Aspects of the disclosure are described more fully hereinafter with reference to the accompanying drawings. This disclosure may, however, be embodied in many different forms and should not be construed as limited to any specific structure or function presented throughout this disclosure. Rather, these aspects are provided so that this disclosure will be thorough and complete, and will fully convey the scope of the disclosure to those skilled in the art. Based on the teachings herein one skilled in the art should appreciate that the scope of the disclosure is intended to cover any aspect of the disclosure, whether implemented independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure may be embodied by one or more elements of a claim.

Many modern electronic products are implemented with multi-layer printed circuit boards. A printed circuit board (PCB) serves as a platform for supporting and connecting various active and/or passive electronic components such as, but not limited to, integrated circuits, transistors, diodes, resistors, capacitors, and inductors. That is, a PCB provides mechanical support for, and electrically conductive interconnect pathways between, the various components disposed on the PCB.

A PCB has a substrate, or base material, which may be made of, for example, fiberglass-reinforced epoxy laminate, but PCBs are not limited to this material. To form electrically conductive pathways, an electrically conductive material, such as, but not limited to, a layer of, for example, copper is formed on the substrate. The electrically conductive material is then etched to form the desired pattern of conductive pathways. When the PCB is populated with components and operated, these conductive pathways may carry, for example, electrical signals. Such conductive pathways may also be referred to as "traces."

In general, a PCB may have a single-sided, double-sided, or multi-layer configuration. A single-sided PCB has electrically conductive pathways on one side thereof. A double-sided PCB has electrically conductive pathways on each of its two sides, i.e., each of its two major opposing surfaces (referred to herein as a top side and a bottom side, respectively). A multi-layer PCB includes multiple layers of patterned electrically conductive material separated by electrically non-conductive insulation, or dielectric, layers. A multi-layer PCB has an outer layer on each of its top side and bottom side, and interior layers between the top side and bottom side.

A recognized issue for the operation of electronic products is the maintenance of stable power supply voltages. Another such issue is the need to reduce high-frequency noise. The reduction of signal coupling and improving of signal integrity are also recognized as issues that can affect circuit performance.

One of the ways of alleviating the above-described issues is by including one or more decoupling capacitors in the design of electronic products. In some instances, decoupling capacitors are sometimes referred to as bypass capacitors. Selecting the magnitude of the capacitance of the decoupling capacitors may depend on the specific requirements of the circuit, product, or system, including but not limited to, the frequency of operation. The physical placement of a decoupling capacitor, i.e., the location of the decoupling capacitor relative to an integrated circuit may impact the effectiveness of that decoupling capacitor. To be most effective, decoupling capacitors are typically placed close to the power pins of an integrated circuit.

Unfortunately, various advances in other aspects of electronic product design and manufacturing have created challenges to achieving the best physical placement of decoupling capacitors. For example, in surface mount technology, surface area limitations proximate to ball grid array (BGA) integrated circuits limit the number of decoupling capacitors that can be placed directly on a given printed circuit board (PCB). And yet, increased switching speeds may require greater amounts of decoupling capacitance. Additionally, increases in the pin-count of BGAs, which results in more board area being used by the BGA, and decreases in the spacing of BGA pads, both limit the area available on a printed circuit board for deploying decoupling capacitors.

In one approach to providing decoupling capacitors between power and ground nodes, multi-layer PCBs may be used for mounting SMD capacitors on the bottom side of a PCB and connecting those capacitors to various power and ground nodes by vias that connect to one or more other layers of the multi-layer PCB. It will be appreciated that such vias may be blind vias or may be vias that go all the through the PCB between the top side and the bottom side. A vias that does not traverse the entire thickness of the PCB but rather provide a path from one side of the PCB to a location within a multi-layer PCB may be referred to as a blind via.

In some electronic product designs there may be a need to share a single ground connection with several decoupling capacitors. Unfortunately, connecting too many decoupling capacitors to a single via pad can lead to a variety of manufacturing difficulties. By way of example and not limitation, placing three 0201 size SMD capacitors on the same via pad of a PCB having a 0.9 mm orthogonal pitch while meeting Design for Manufacturability rules for pick-and-place, solderability, and/or rework present challenges.

Various embodiments in accordance this disclosure provide solutions for the above-described issues, as well as for other pitches and component sizes where multiple two-terminal SMD components, such as but not limited to capacitors, share a single via pad.

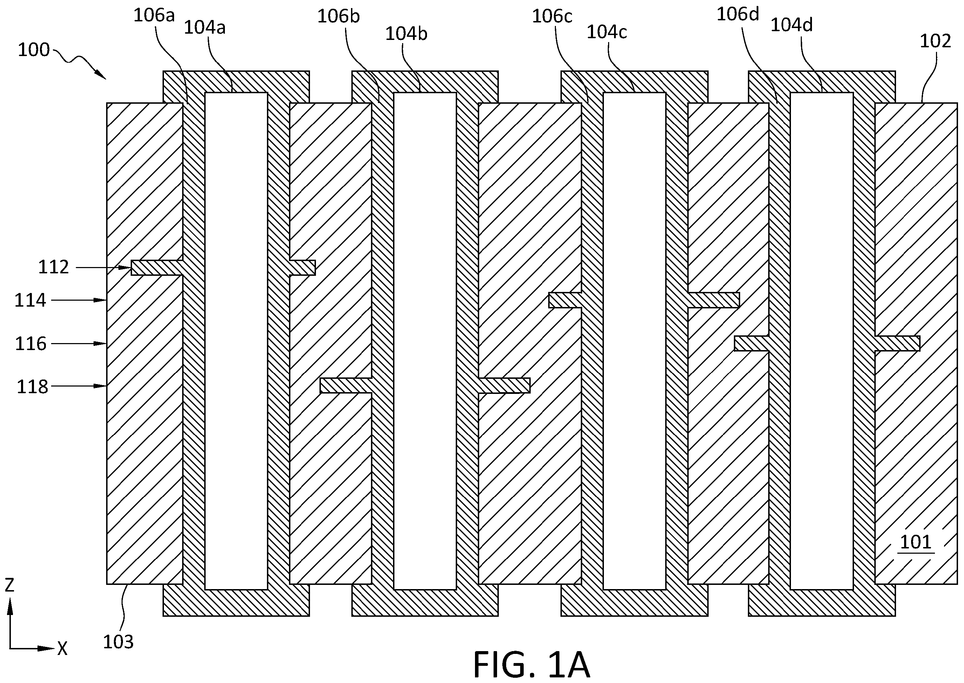

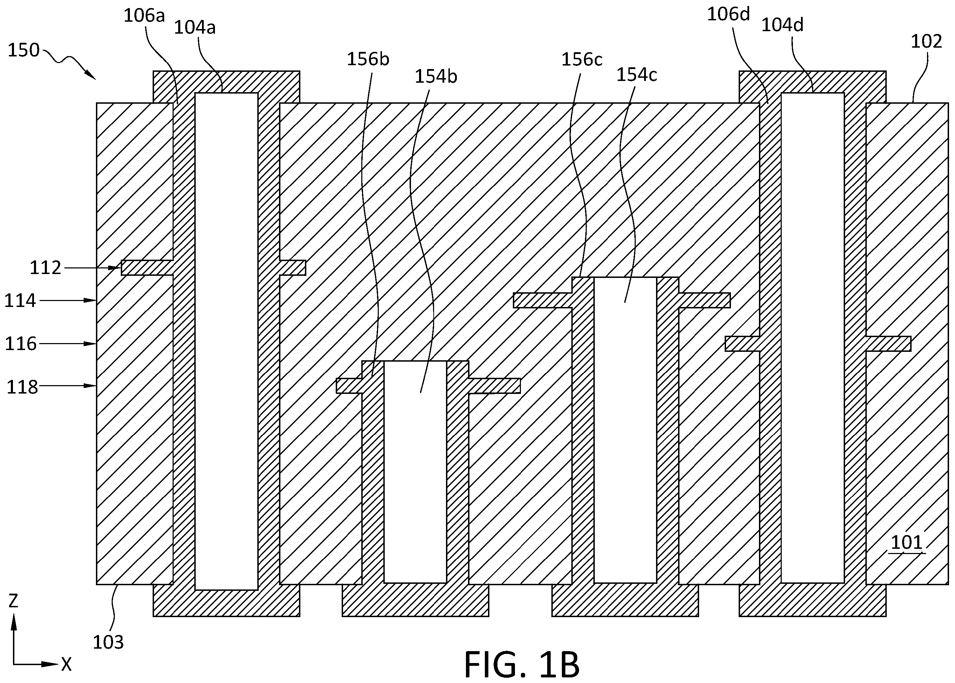

FIGs. 1A and 1B illustrate various features of multi-layer printed circuit boards, wherein FIG. 1A shows a printed circuit board having vias from the top side to the bottom side, and FIG. 1B shows a printed circuit board having blind vias in addition to vias from the top side to the bottom side.

FIG. 1A is an illustrative cross-sectional view of a portion of a multi-layer printed circuit board (PCB) **100** having a substrate **101** with a top side **102** and a bottom side **103.** PCB **100** includes vias **104a, 104b, 104c,** and **104d,** each of those vias between top side **102** and bottom side **103.** Vias **104a, 104b, 104c,** and **104d** each includes a conductive barrel **106a, 106b, 106c,** and **106d,** respectively. Conductive barrels **106a, 106b, 106c,** and **106d** are the plated inner walls of, respectively, vias **104a, 104b, 104c,** and **104d.** Conductive barrels **106a, 106b, 106c,** and **106d** may be, but are not limited to copper, each of these conductive barrels provide a corresponding electrical path from top side **102** to bottom side **103.** As shown in FIG. 1A, top side **102** and bottom side **103** are nominally parallel to each other, and vias **104a, 104b, 104c,** and **104d** are nominally perpendicular to top side **102** and to bottom side **103.**

FIG. 1A also shows a first conductive structure **112** on a first conductive interior layer of PCB **100,** a second conductive structure **114** on a second conductive interior layer of PCB **100,** a third conductive structure **116** on a third conductive interior layer of PCB **100,** and a fourth conductive structure **118** on a fourth conductive interior layer of PCB **100.** Each conductive interior layer of PCB **100** has an insulating, or dielectric, layer above and below it. Conductive structures **112, 114, 116,** and **118** may be, but are not limited to, copper.

First conductive structure **112** may be, for example, a signal trace or a voltage plane. Likewise, second conductive structure **114,** third conductive structure **116,** and fourth conductive structure **118** may be a signal trace or a voltage plane. In some embodiments, a voltage plane may be coupled to one of two or more power supply nodes. By way of example and not limitation, a power supply node may be a positive power supply node or a ground node.

Still referring to FIG. 1A, first conductive structure **112** is shown to be in contact with conductive barrel **106a,** fourth conductive structure **118** is shown to be in contact with conductive barrel **106b,** second conductive structure **114** is shown to be in contact with conductive barrel **106c,** and third conductive structure **116** is shown to be in contact with conductive barrel **106d.**

FIG. 1B is an illustrative cross-sectional view of a portion of a multi-layer PCB **150** having a substrate **101** with a top side **102** and a bottom side **103.** PCB **150** includes vias **104a, 154b, 154c,** and **104d.** Vias **104a** and **104d** are plated through vias between top side **102** and bottom side **103.** Vias **154b** and **154c** are blind vias between bottom side **103** and interior layers of PCB **150.** In this particular illustrative PCB **150,** via **154b** is between bottom side **103** and fourth conductive structure **118;** and via **154c** is between bottom side **103** and second conductive structure **114.**

Still referring to FIG. 1B, first conductive structure **112** is shown to be in contact with conductive barrel **106a,** fourth conductive structure **118** is shown to be in contact with a conductive barrel **156b,** second conductive structure **114** is shown to be in contact with a conductive barrel **156c,** and third conductive structure **116** is shown to be in contact with conductive barrel **106d.**

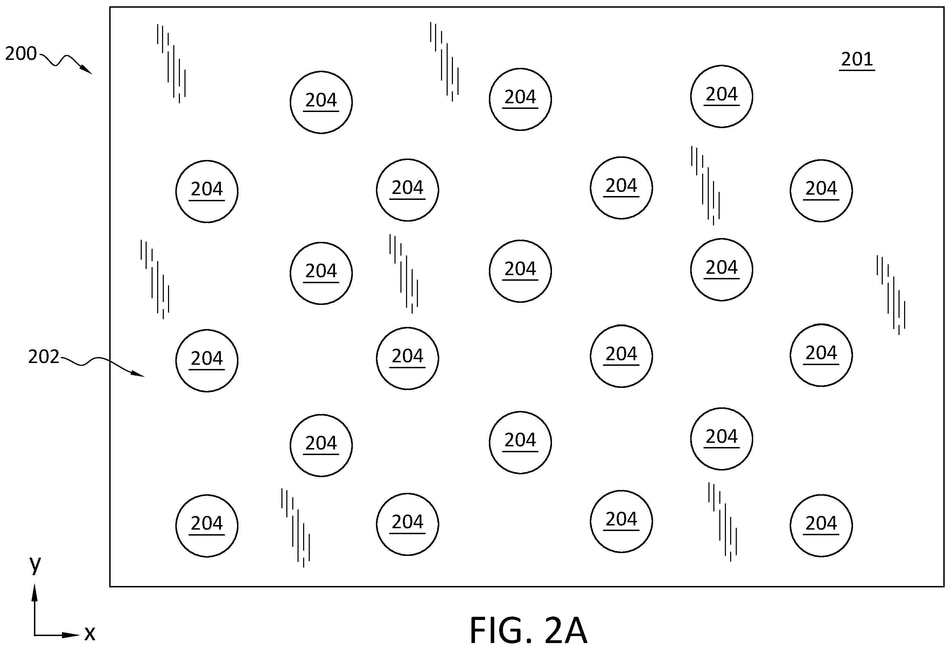

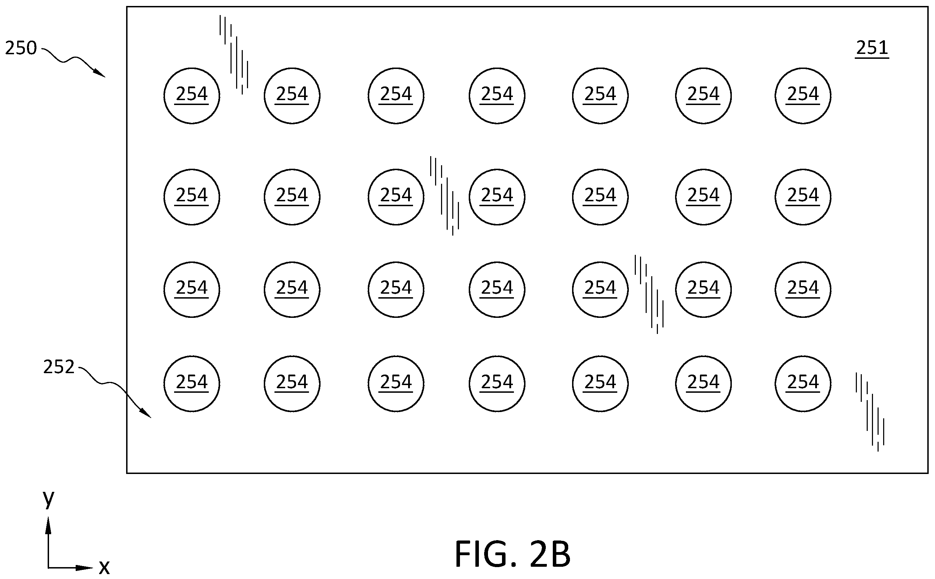

FIGs. 2A and 2B illustrate PCBs having via pad layout patterns for orthogonal and non-orthogonal arrangements, respectively.

FIG. 2A is a bottom view of a portion of a multi-layer PCB **200** having a substrate **201,** and a bottom side **202** with an orthogonal arrangement of via pads **204.** In the orthogonal arrangement each via pad **204** is nominally equidistant from the via pads **204** that surround it. In this arrangement one via pad **204** may be surrounded by six other via pads **204** as shown in FIG. 2A. Although FIG. 2A illustrates bottom side **202,** it is also possible to have at least a portion of the top side of a PCB with an orthogonal arrangement of via pads. It is noted that each via pad **204** may be connected to a blind via, or to a through via that provides an electrical path between the bottom side **202** and a top side of PCB **200.**

FIG. 2B is a bottom view of a portion of a PCB **250** showing a non-orthogonal arrangement of via pads. PCB includes a substrate **251** having a bottom side **252,** and a regular array of via pads **254** in a non-orthogonal configuration. In this arrangement one via pad **254** (referred to a central via) may be surrounded by eight other via pads **254** as shown in FIG. 2B. However, in the non-orthogonal arrangement, these eight surrounding via pads are not equally spaced from the central via pad.

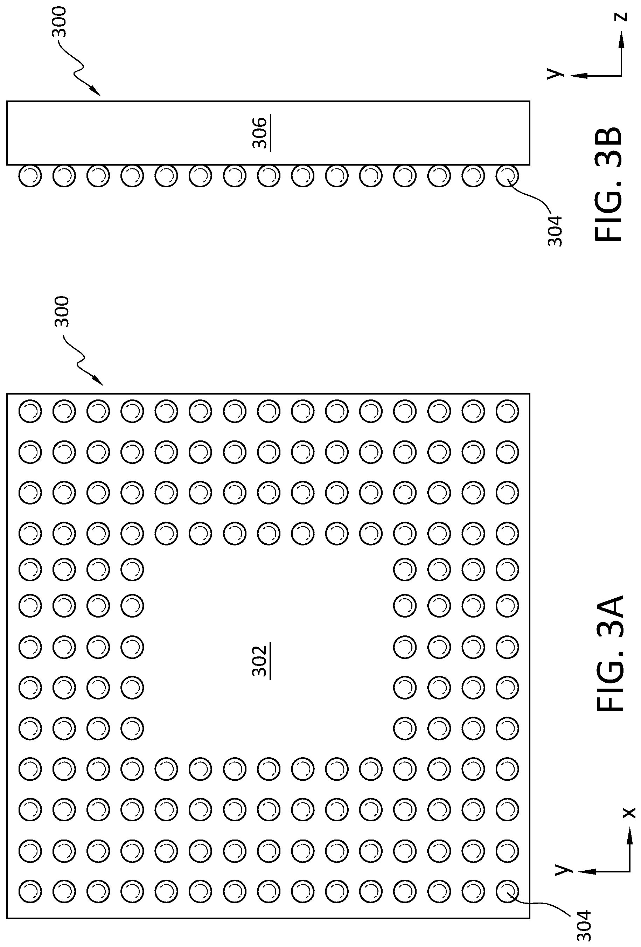

FIGs. 3A and 3B show a bottom view and a side view of an illustrative ball grid array package, respectively.

FIG. 3A shows an example of a ball grid array (BGA) package **300.** BGA package **300** may be disposed on, and electrically coupled to, a printed circuit board by surface mount technology. BGA package **300** has a bottom surface **302,** the exposed portion of which is non-conductive, and a plurality of solder balls **304** attached thereto. Solder balls **304** provide electrical connections between a chip in the BGA package and conductive traces on the PCB. FIG. 3A shows the "footprint," of BGA package **300,** i.e., the area that BGA package **300** covers on a PCB.

FIG. 3B is a side view of example BGA package **300,** and more particularly shows a thickness (in the z-direction) of BGA package **300.**

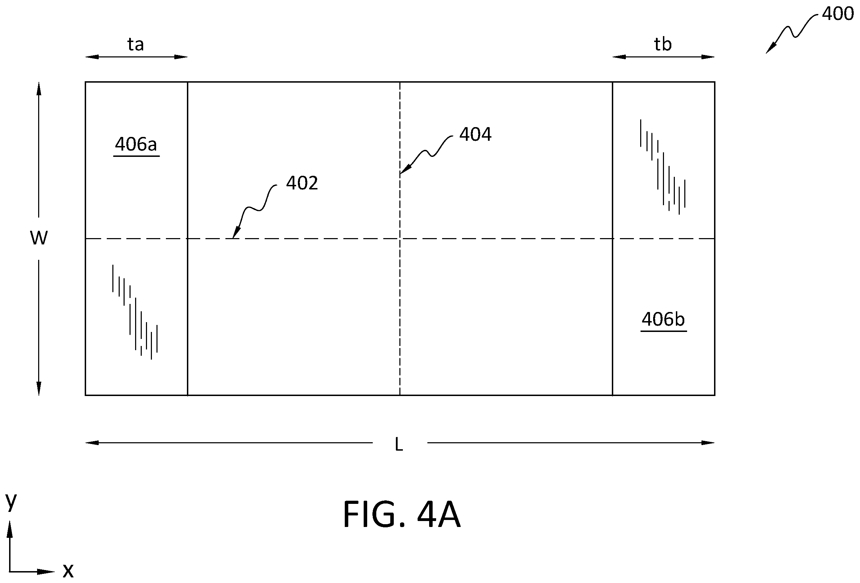

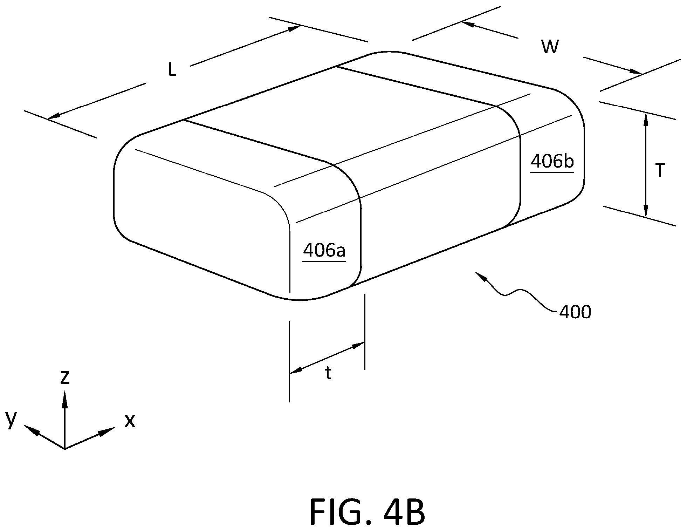

FIGs. 4A and 4B show, respectively, a top view and a perspective view of a two-terminal surface mount device package.

FIG. 4A is a top view of an example two-terminal surface mount device (SMD) **400.** SMD **400** may be any two-terminal electrical component including, but not limited to, a capacitor, a resistor, or an inductor. SMD **400** has a length (L), a width (W), a horizontal axis **402** (in the x-direction), and a vertical axis **404** (in the y-direction, SMD **400** further has a first solderable area **406a** and a second solderable area **406b.** In this example, first solderable area **406a** has a width (W) and a length (tₐ); and second solderable area **406b** has a width (W) and a length (t_{b}). In this example, tₐ and t_{b} are nominally the same length. It is noted that there are many commercially available SMD components that are provided in a number of standardized sizes, for example the 0201 size has a length of 0.6 mm, and a width of 0.3 mm.

FIG. 4B is a perspective view of the two-terminal SMD **400** of FIG. 4A. In addition to the length (L), width (W), first solderable area **406a** and a second solderable area **406b** that are shown in FIG. 4A, this view shows further shows the thickness (T) of SMD **400.** The thickness (T) for 0201 SMD components varies depending on the type pf component and the manufacturer.

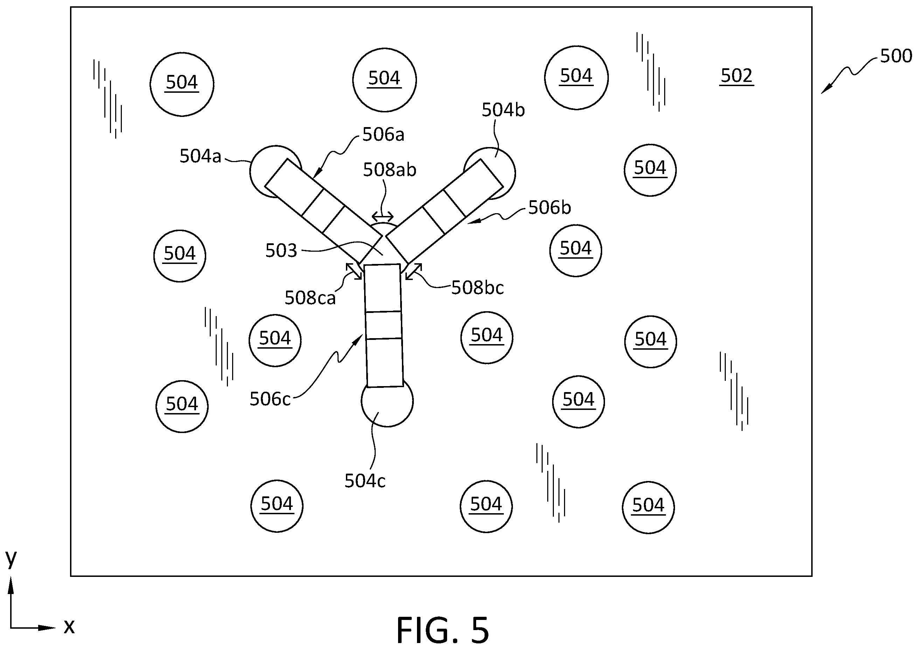

FIG. 5 is a bottom view of a portion of a multi-layer PCB **500.** PCB **500** includes a substrate **502,** and a plurality of via pads **503, 504, 504a, 504b,** and **504c,** disposed in an orthogonal arrangement. Three SMD components **506a, 506b,** and **506c** are mounted on the bottom side of PCB **500.** Each of the three SMD components **506a, 506b,** and **506c** is a two-terminal device. SMD component **506a,** is coupled between a via pad **503** and a first via pad **504a,** SMD component **506b,** is coupled between via pad **503** and a second via pad **504b,** and SMD component **506c,** is coupled between via pad **503** and a third via pad **504c.** As shown in FIG. 5, in the neighborhood of via pad **503** there is a space **508ab** between SMD components **506a** and **506b,** a space **508bc** between SMD components **506b** and **506c,** and a space **508ca** between SMD components **506c** and **506a.** Spaces **508ab, 508bc,** and **508ca** may also be referred to as component gaps.

Still referring to FIG. 5, when the three SMD components **506a, 506b,** and **506c** are arranged in this way the spacings **508ab, 508bc,** and **508ca** between them in the neighborhood of the common via pad **503** may be inadequate to prevent solderability issues such as tombstoning. Further, this spacing may be inadequate for successfully placing these components using pick-and-place machines. Still further, this spacing may create unwanted difficulties in various rework processes./

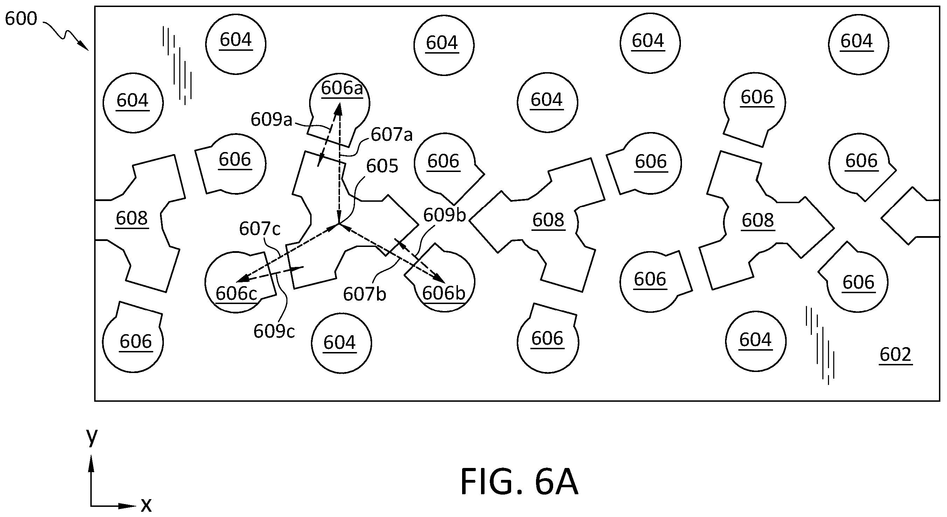

FIG. 6A is a bottom view of an illustrative multi-layer PCB **600** showing a via pad layout, in accordance with this disclosure. Via pad layouts in accordance with this disclosure may be used to provide adequate component gaps when placing multiple SMD components, such as but not limited to capacitors, so as to meet a manufacturer's Design for Manufacturability rules. Meeting such design rules results in higher manufacturing yields and lower costs.

FIG. 6A illustrates a portion of a patterned conductive layer on the bottom side of PCB **600.** More particularly, PCB **600** includes a plurality of via pads **604, 605, 606, 606a, 606b,** and **606c.** In this illustrative embodiment, via pads **604** are nominally circular. Via pads **605** and **608** each have a central portion and a plurality of central-extensions that extend outwardly therefrom. Via pads **606, 606a, 606b,** and **606c** each have a central portion that is nominally circular and an extension that extends outwardly therefrom.

Still referring to FIG. 6A, a first via-to-via axis **607a** is shown between via pad **605** and via pad **606a,** a second via-to-via axis **607b** is shown between via pad **605** and via pad **606b,** and a third via-to-via axis **607c** is shown between via pad **605** and via pad **606c.** Further a first component-axis **609a** is shown between an extension of via pad **606a** and a first extension of via pad **605,** a second component-axis **609b** is shown between an extension of via pad **606b** and a second extension of via pad **605,** and a third component-axis **609c** is shown between an extension of via pad **606c** and a third extension of via pad **605.** Note that first component-axis **609a** is angled away from first via-to-via axis **607a,** second component-axis **609b** is angled away from second via-to-via axis **607b,** and third component-axis **609c** is angled away from second via-to-via axis **607c.** In some embodiments, each of the angles between the component-axes and corresponding via-to-via axes is nominally fifteen degrees. In other embodiments, angles other than fifteen degrees may be used to achieve component gaps large enough that the spacing between components meets the desired Design For Manufacturability rules.

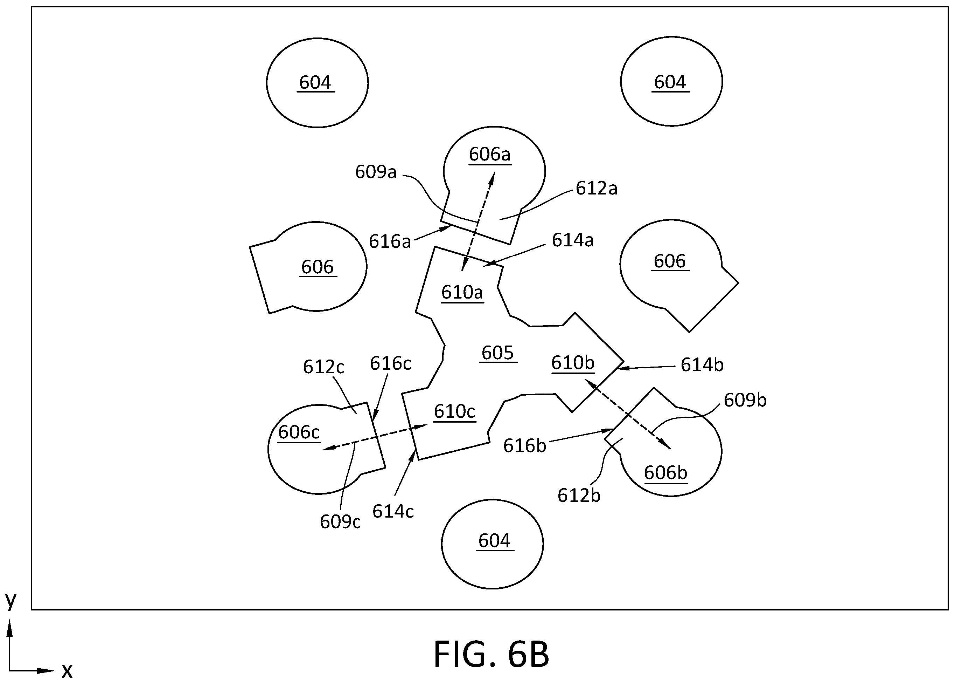

FIG. 6B is an enlarged view of a portion of FIG. 6A. This enlarged view facilitates additional description of the illustrative embodiment of FIG. 6A. As shown in FIG. 6B, via pad **605** has a first central-extension **610a,** a second central-extension **610b,** and a third central-extension **610c.** First central-extension **610a** has a first central-connection-edge **614a,** second central extension **610b** has a second central-connection-edge **614b,** and third central extension **610c** has a third central-connection-edge **614c.** Via pad **606a** has a first extension **612a,** via pad **606b** has second extension **612b,** and via pad **606c** has a third extension **612c.** First extension **612a** has a first connection-edge **616a,** second extension **612b** has a second connection-edge **616b,** and third extension **612c** has a third connection-edge **616c.**

Still referring to FIG. 6B, it can be seen that first central-connection-edge **614a** and first connection-edge **616a** face each other, second central-connection-edge **614b** and second connection-edge **616b** face each other, and third central-connection-edge **614c,** and first connection-edge **616c,** face each other. Note that first component-axis **609a,** second component-axis **609b,** and third component-axis 609c indicate the way in which the horizontal axis of a two-terminal SMD component would align when placed.

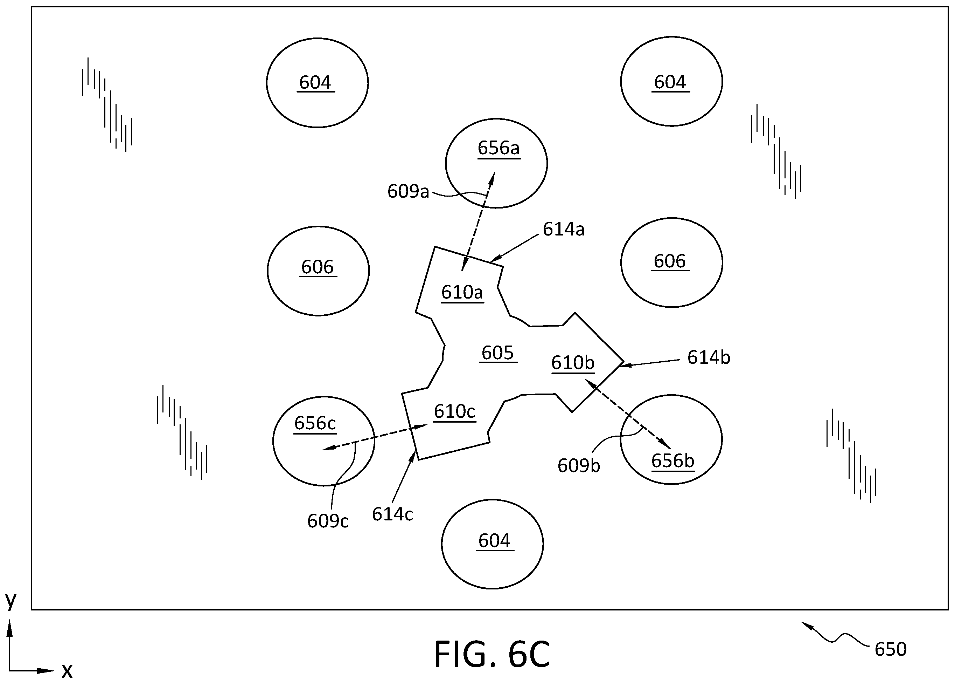

FIG. 6C shows an alternative embodiment similar to that shown in FIGs. 6A - 6B. The alternative embodiment of FIG. 6C differs from the illustrative embodiment of FIGs. 6A - 6B in that first, second, and third via pads **656a, 656b,** and **656c** are nominally circular and do not have extensions extending outwardly therefrom as do first, second, and third via pads **606a, 606b,** and **606c.**

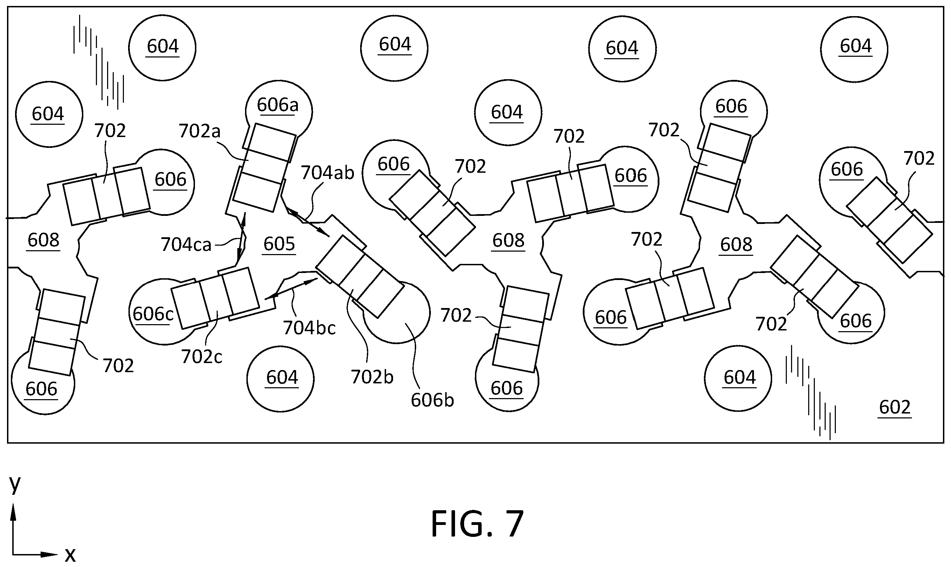

FIG. 7 is a bottom view of PCB **600,** after a plurality of SMD components **702, 702a, 702b,** and **702c** have be placed in accordance with this disclosure. It will be appreciated that after placement of SMD components **702, 702a, 702b,** and **702c** one or more further operations such as a reflow solder operation may be performed.

Referring to FIGs. 4, 6A and 7, it can be seen that SMD component **702a** is positioned between via pad **606a** and via pad **605** such that the horizontal axis of SMD component **702a** is angled away from via-to-via axis **607a.** SMD component **702b** is positioned between via pad **606b** and via pad **605** such that the horizontal axis of SMD component **702b** is angled away from via-to-via axis **607b.** SMD component **702c** is positioned between via pad **606c** and via pad **605** such that the horizontal axis of SMD component **702c** is angled away from via-to-via axis **607c.**

FIG. 7 further shows that, in the neighborhood of via pad **605,** there is a spacing **704ab** between SMD components **702a** and **702b,** a spacing **704bc** between SMD components **702b** and **702c,** and a spacing **704ca** between SMD components **702c** and **702a.** Because this arrangement, in accordance with this disclosure, provides greater spacing between the SMD components in the neighborhood of via pad **605,** Design for Manufacturability rules to prevent problems with pick-and-place, solderability, and rework can be met while still connecting three SMD components to a common via pad.

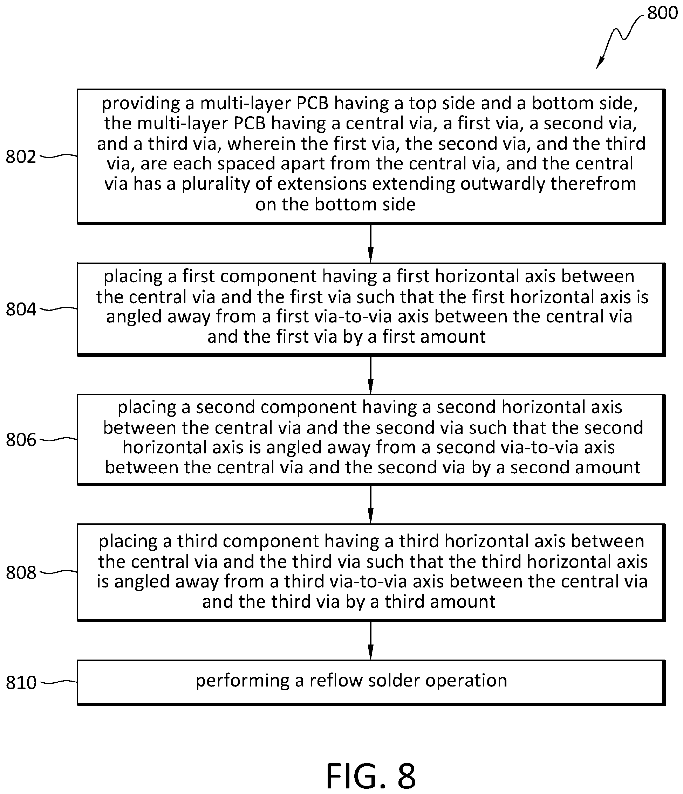

FIG. 8 is a flow diagram of an illustrative method **800** of manufacturing an electronic product in accordance with this disclosure. Method **800** includes providing **802** a multi-layer printed circuit board (PCB) having a top side and a bottom side, the multi-layer PCB having a central via, a first via, a second via, and a third via, wherein the first via, the second via, and the third via, are each spaced apart from the central via, and the central via has a plurality of extensions extending outwardly therefrom on the bottom side. Method **800** includes placing **804** a first component having a first horizontal axis between the central via and the first via such that the first horizontal axis is angled away from a first via-to-via axis between the central via and the first via by a first amount. The first component may be a surface-mount device. In some embodiments, the first component may be a two-terminal surface-mount device such as, but not limited to, a capacitor. Method **800** includes placing **806** a second component having a second horizontal axis between the central via and the second via such that the second horizontal axis is angled away from a second via-to-via axis between the central via and the second via by a second amount. Like the first component, the second component may be a surface-mount device. In some embodiments, the second component may be a two-terminal surface-mount device such as, but not limited to, a capacitor. Method **800** includes placing **808** a third component having a third horizontal axis between the central via and the third via such that the third horizontal axis is angled away from a third via-to-via axis between the central via and the third via by a third amount. Like the first and second components, the third component may be a surface-mount device. In some embodiments, the third component may be a two-terminal surface-mount device such as, but not limited to, a capacitor. In alternative embodiments, one or more of the above-mentioned two-terminal surface-mount devices may a resistor. In still other alternative embodiments, one or more of the two-terminal surface-mount devices may be an inductor.

Still referring to FIG. 8, in some embodiments the first, second, and third components may be provided in 0201-size SMD packages. However, in accordance with method **800,** the first, second, and third components are not limited to any particular package size. Method **800** further includes performing **810** a reflow solder operation. In some embodiments, a solder paste is disposed on portions of the bottom side of the multi-layer PCB prior to placing the first, second, and third components.

In accordance with the illustrative method **800,** the first component is placed such that a first one of its terminals is closer to the central via than a second one of its terminals. Likewise, the second component is placed such that a first one of its terminals is closer to the central via than a second one of its terminals. Further, the third component is placed such that a first one of its terminals is closer to the central via than a second one of its terminals. In this arrangement (see FIG. 7), there is a first component gap between the first component and the second component, a second component gap between the second component and the third component, and a third component gap between the third component and the first component; and the first, second, and third component gaps are each greater than a predetermined distance. In some embodiments, the predetermined distance is based on the spacing between components specified by Design for Manufacturability (DFM) rules of a particular manufacturing process. For example, if a component gap is too small then a manufacturing problem such as, but not limited to, tombstoning during a reflow solder operation may be more likely to occur. In another example, if a component gap is too small then a manufacturing problem such as, difficulty in performing rework may be more likely to occur.

According to a further aspect of this disclosure, a multi-layer PCB having a top side and a bottom side, includes a plurality of voltage-plane layers, each voltage-plane layer having at least one voltage plane; a first ground-plane layer having at least one ground plane; a central via having a plurality of conductive extensions extending outwardly therefrom on the bottom side, the central via coupled to the at least one ground plane; a first via, a second via, and a third via, each spaced apart from the central via; a first surface mount device (SMD) having a first horizontal axis, the first SMD disposed on the multi-layer PCB between a first extension of the plurality of extensions and the first via, such that the first horizontal axis is angled by a first amount greater than a predetermined threshold angle relative to a first via-to-via axis between the central via and the first via; and a second SMD having a second horizontal axis, the second SMD disposed on the multi-layer PCB between a second extension of the plurality of extensions and the second via, such that the second horizontal axis is angled by a second amount greater than the predetermined threshold angle relative to a second via-to-via axis between the central via and the second via, wherein the first SMD and the second SMD are each two-terminal devices. In some embodiments, the threshold angle is an angle that produces adequate spacing, i.e., component gaps, so the manufacturer's Design for Manufacturability rules are met.

In some embodiments, the multi-layer PCB further includes a third SMD having a third horizontal axis, the third SMD disposed on the multi-layer PCB between a third extension of the plurality of extensions and the third via, such that the third horizontal axis is angled by a third amount greater than the predetermined threshold angle relative to a third via-to-via axis between the central via and the third via, wherein the first via, the second via, and the third via are nominally equidistant from the central via, and wherein the first via is coupled to a first voltage plane, the second via is coupled to a second voltage plane, the third via is coupled to a third voltage plane, and the central via is coupled to a first ground plane.

In some embodiments of the multi-layer PCB, the first amount, the second amount, and the third amount, are nominally the same.

In some embodiments of the multi-layer PCB, the first amount, the second amount, and the third amount, are each nominally fifteen degrees, and the first component, the second component, and the third component, each comprise a capacitor.

In some embodiments the multi-layer PCB, further includes a plurality of signal-trace layers, each signal-trace layer having a plurality of signal traces; and at least one SMD disposed on the top side of the multi-layer PCB, wherein at least one of the first component, the second component, and the third component is an 0201 size component.

The foregoing disclosure provides illustration and description, but is not intended to be exhaustive or to limit the aspects to the precise form disclosed. Modifications and variations may be made in light of the above disclosure or may be acquired from practice of the aspects.

As used herein, the term "vertical/vertically" means nominally orthogonal to the surface of the object being referenced.

As used herein, the term "nominal/nominally" refers to a desired, or target, value of a characteristic or parameter for a component or a process operation, set during the design phase of a product or a process, together with a range of values above and/or below the desired value. The range of values can be due to slight variations in manufacturing processes or tolerances.

As used herein, the term "about" indicates the value of a given quantity may vary from its nominal value based on, for example, various manufacturing tolerances. By way of example, and not limitation, the term "about" may indicate the cited value of a given quantity may vary within, for example, 1-30% of the value (e.g., ±0.5%, ±1%, ±5%, ±10%, ±20%, or ±30% of the value). Specific ranges are provided herein when needed.

Unless stated otherwise, terms such as "first" and "second" are used to arbitrarily distinguish between the elements such terms describe. Thus, these terms are not necessarily intended to indicate temporal or other prioritization of such elements.

It should be appreciated by those skilled in the art that any block diagrams herein represent conceptual views of illustrative hardware embodying the principles of the aspects.

While each of the embodiments are described above in terms of their structural arrangements, it should be appreciated that the aspects also cover the associated methods of using the embodiments described above.

Even though particular combinations of features are recited in the claims and/or disclosed in the specification, these combinations are not intended to limit the disclosure of various aspects. In fact, many of these features may be combined in ways not specifically recited in the claims and/or disclosed in the specification. Although each dependent claim listed below may directly depend on only one claim, the disclosure of various aspects includes each dependent claim in combination with every other claim in the claim set. A phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

No element, act, or instruction used herein should be construed as critical or essential unless explicitly described as such. Also, as used herein, the articles "a" and "an" are intended to include one or more items, and may be used interchangeably with "one or more." Furthermore, as used herein, the terms "set" and "group" are intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," and/or the like are intended to be open-ended terms. Further, the phrase "based on" is intended to mean "based, at least in part, on" unless explicitly stated otherwise.

Although the various exemplary embodiments have been described in detail with particular reference to certain exemplary aspects thereof, it should be understood that the invention is capable of other embodiments and its details are capable of modifications in various obvious respects. As is readily apparent to those skilled in the art, variations and modifications can be affected while remaining within the spirit and scope of the invention. Accordingly, the foregoing disclosure, description, and figures are for illustrative purposes only and do not in any way limit the invention, which is defined only by the subjacent claims.

## Claims

1. An electronic product, comprising:
a substrate having a top side and a bottom side;
a first via pad having a plurality of extensions extending outwardly therefrom, disposed on the bottom side;
a second via pad;
a third via pad;
a first component having a first horizontal axis, a first terminal, and a second terminal, the first component disposed on the bottom side between the second via pad and a first extension of the plurality of extensions such that the first horizontal axis forms an angle α with respect to a first via-to-via axis line between the first via pad and the second via pad, wherein α is greater than a threshold angle; and
a second component having a second horizontal axis, a third terminal, and a fourth terminal, the second component disposed on the bottom side between the third via pad and a second extension of the plurality of extensions such that the second horizontal axis forms an angle β with respect to a second via-to-via axis line between the first via pad and the third via pad, wherein β is greater than the threshold angle.

2. The electronic product of claim 1, wherein the first terminal is coupled to the second via pad, the second terminal is coupled to the first extension, the third terminal is coupled to the third via pad, the fourth terminal is coupled to the second extension, and a first component gap between the second terminal and the fourth terminal is greater than a threshold distance.

3. The electronic product of claim 2, further comprising:
a fourth via pad; and
a third component having a third horizontal axis, a fifth terminal, and a sixth terminal, the third component disposed on the bottom side between the fourth via pad and a third extension of the plurality of extensions such that the third horizontal axis forms an angle γ with respect to a third via-to-via axis line between the first via pad and the fourth via pad, wherein γ is greater than the threshold angle,
wherein a second component gap between the fourth terminal and sixth terminal is greater than the threshold distance, and a third component gap between the second terminal and sixth terminal is greater than the threshold distance.

4. The electronic product of claim 3, wherein angle α, angle β, and angle γ, are nominally the same angle.

5. The electronic product of claim 3, wherein a magnitude of the threshold angle is such that the first component gap, the second component gap, and the third component gap are greater than the threshold distance.

6. The electronic product of claim 3, further comprising:
a fourth component disposed on the top side of the substrate;
a first ground plane coupled to the first via pad;
a first power plane coupled to the second via pad;
a second power plane coupled to the third via pad; and
a third power plane coupled to the fourth via pad,
wherein the substrate is a multi-layer substrate, and the first power plane, the second power plane, and the third power plane are each on a different layer of the multi-layer substrate.

7. The electronic product of claim 6, wherein the first component, the second component, the third component, and the fourth component are each a surface-mount device.

8. The electronic product of claim 7, wherein at least one of the first component, the second component, and the third component comprises a capacitor.

9. The electronic product of claim 7, wherein the fourth component comprises a ball grid array package.

10. The electronic product of claim 1, wherein the substrate comprises a multi-layer printed circuit board.

11. A method of manufacturing an electronic product, comprising:
providing a multi-layer printed circuit board (PCB) having a top side and a bottom side, the multi-layer PCB having a central via pad, a first via pad, a second via pad, and a third via pad, wherein the first via pad, the second via pad, and the third via pad, are each spaced apart from the central via pad, and the central via pad has a plurality of extensions extending outwardly therefrom on the bottom side;
placing a first component having a first horizontal axis between the central via pad and the first via pad such that the first horizontal axis is angled away from a first via-to-via axis between the central via pad and the first via pad by a first amount;
placing a second component having a second horizontal axis between the central via pad and the second via pad such that the second horizontal axis is angled away from a second via-to-via axis between the central via pad and the second via pad by a second amount;
placing a third component having a third horizontal axis between the central via pad and the third via pad such that the third horizontal axis is angled away from a third via-to-via axis between the central via pad and the third via pad by a third amount; and
performing a reflow solder operation,
wherein a first component gap between the first component and the second component, a second component gap between the second component and the third component, and a third component gap between the third component and the first component, are each greater than a predetermined distance.

12. The method of claim 15, wherein each of the first component, the second component, and the third component are two-terminal, surface-mount devices, and the first via pad, the second via pad, and the third via pad are nominally equidistant from the central via pad.

13. The method of claim 12, wherein the first component, the second component, and the third component are each 0201 size capacitors disposed on the bottom side, and further comprising:
placing a fourth component on the top side, wherein the fourth component is a surface-mount device, and the fourth component is located vertically over the central via pad.

14. The method of claim 13, wherein the central via pad is coupled to a ground plane, the first via pad is coupled to a first voltage plane, the second via pad is coupled to a second voltage plane, and the third via pad is coupled to a third voltage plane.

15. The method of claim 11, wherein the first amount, the second amount, and the third amount, are nominally the same.
